Europäisches Patentamt

European Patent Office                    (11) Numéro de publication:          **0 223 287**

Office européen des brevets                                                 **A1**

(12)                                   **DEMANDE DE BREVET EUROPEEN**

(21) Numéro de dépôt: **86201915.5**        (51) Int. Cl.⁴ **H03D 7/12 , H03D 7/14**

(22) Date de dépôt: **03.11.86**

(30) Priorité: **05.11.85 FR 8516376**      (71) Demandeur: **Laboratoires d'Electronique et
                                          de Physique Appliquée L.E.P.
(43) Date de publication de la demande:       3, Avenue Descartes
    **27.05.87 Bulletin 87/22**             F-94450 Limeil-Brévannes(FR)
                                           FR**
(84) Etats contractants désignés:            Demandeur: **N.V. Philips'
    **DE ES FR GB**                         Gloeilampenfabrieken
                                           Groenewoudseweg 1
                                           NL-5621 BA Eindhoven(NL)
                                           DE ES GB**
                                          (72) Inventeur: **Dautriche, Pierre Bernard
                                           Société Civile S.P.I.D.209 rue de l'Université
                                           F-75007 Paris(FR)**

                                          (74) Mandataire: **Landousy, Christian et al
                                           Société Civile S.P.I.D. 209, Rue de
                                           l'Université
                                           F-75007 Paris(FR)**

(54) Dispositif semiconducteur du type mélangeur.

(57) Dispositif semiconducteur du type mélangeur, formé d'au moins un étage amplificateur à gain variable incluant un premier transistor à effet de champ $T_1$ dont la première borne principale dite drain est polarisée à travers une charge $T_3$ par une alimentation continue $V_{DD}$, et dont la borne de commande dite grille reçoit un premier signal RF à une première fréquence, lequel est modulé par un second signal OL à une seconde fréquence appliqué à l'étage amplificateur à travers une résistance variable $T_2$, en sorte que le signal de sortie IF de l'étage amplificateur disponible sur la première borne principale dite drain du premier transistor $T_1$ est formé du mélange du premier et du second signal, caractérisé en ce que le second signal OL est appliqué à travers la résistance variable $T_2$ sur la première borne principale dite drain du premier transistor $T_1$, en sorte que la variation du gain de l'amplificateur est engendrée par la modulation de la charge constituée par $T_3$ et $T_2$, et caractérisé en ce que la seconde borne principale dite source du premier transistor $T_1$ est directement portée à un potentiel de référence $V_M$.

FIG. 2

EP 0 223 287 A1

## DISPOSITIF SEMICONDUCTEUR DU TYPE MELANGEUR

L'invention concerne un dispositif semiconducteur du type mélangeur, formé d'au moins un étage amplificateur à gain variable incluant un premier transistor à effet de champ T, dont la première borne principale dite drain est polarisée à travers une charge $T_3$ par une alimentation continue $V_{DD}$ et dont la borne de commande dite grille reçoit un premier signal RF pour être mélangé à un second signal OL appliqué au premier transistor à effet de champ T, à travers une résistance variable $T_2$, en sorte que le signal de sortie IF de l'étage amplificateur disponible sur la première borne principale dite drain du premier transistor T, est formé du mélange du premier et du second signal.

Ce dispositif trouve son application dans le traitement de signaux, par exemple hyperfréquences, dans le domaine de la réception des émissions de télévision.

Un tel dispositif mélangeur est connu de l'art antérieur par la publication de Rory Van Tuyl dans "1980 IEEE Solid State Circuits Conference" à l'issue de "ISSCC 80, Thursday, February 14, Session X = Microwave Circuits, pages 118, 119", intitulée "A monolithic GaAs FET RF Signal Generation Chip".

Cette publication décrit en particulier un dispositif mélangeur comprenant un étage amplificateur formé d'un premier transistor à effet de champ constituant la partie amplificateur proprement dite. L'électrode de commande ou grille du premier transistor reçoit un premier signal à une première fréquence, qui est modulé par un second signal à une seconde fréquence. Ce second signal est appliqué sur la source du premier transistor, par l'intermédiaire d'un second transistor à effet de champ utilisé comme une résistance variable. Le premier transistor dit amplificateur est polarisé par rapport à l'alimentation continue par une charge appliquée sur son drain, et par rapport à la masse par un troisième transistor encore appliqué sur sa source et monté en source de courant, en sorte que cet étage fonctionne comme un amplificateur à contre-réaction de courant. Le mélange du premier et du second signal est disponible sur le drain du premier transistor et constitue la sortie de l'amplificateur à gain variable. Le troisième transistor utilisé comme source de courant présente une forte impédance afin d'interférer le moins possible dans la fonction du mélangeur. Le second transistor utilisé comme résistance variable reçoit le signal d'un oscillateur local sur sa grille et est placé dans les conditions où sa tension drain-source est équivalente à zéro.

Le document cité décrit particulièrement un montage double et équilibré de ce mélangeur, montage permettant d'améliorer l'isolation entre portes, c'est-à-dire d'obtenir une bonne isolation entre le signal de l'oscillateur local, le signal d'entrée du mélangeur et le signal de sortie.

Le circuit mélangeur décrit dans le document cité présente deux graves inconvénients. Le premier inconvénient réside dans le fait que le facteur de bruit de ce circuit est très élevé. Ceci est dû à la présence d'éléments bruyants appliqués sur la source du premier transistor dit amplificateur. Un élément bruyant est, entre autres, le transistor utilisé comme source de courant. Le second inconvénient réside dans le fait que les bonnes conditions de polarisation du transistor amplificateur sont difficiles à obtenir.

Le but de la présente invention est donc de s'affranchir des inconvénients cités.

Ce but est atteint au moyen d'un dispositif tel que décrit dans le préambule et caractérisé en ce que le second signal OL est appliqué à travers la résistance variable $T_2$ sur la première borne principale dite drain du premier transistor $T_1$, en sorte que la variation du gain de l'amplificateur est engendré par la modulation de la charge constituée par $T_3$ et $T_2$.

Ce dispositif peut être en outre caractérisé en ce que la seconde borne principale du premier transistor T, est directement portée à un potentiel de référence $V_M$.

Le dispositif du type mélangeur conforme à la présente invention présente alors, entre autres, les avantages suivants :

a) le facteur de bruit de ce mélangeur est considérablement amélioré par rapport à celui du mélangeur considéré comme état de la technique ;

b) la polarisation de l'étage amplificateur est obtenue de façon plus aisée ;

c) le gain de conversion est très bon ;

d) la tension d'alimentation nécessaire au fonctionnement du nouveau dispositif est plus faible que selon l'art antérieur donc la consommation en puissance est diminuée.

Le dispositif mélangeur selon l'invention peut encore être formé de deux de ces étages amplificateurs à gain variable identiques et couplés, recevant respectivement le second signal OL et son complémentaire $\overline{OL}$, et fournissant le signal de sortie IF et son complémentaire $\overline{IF}$.

Dans une forme de réalisation particulière de ce dispositif, le second signal OL et son complémentaire $\overline{OL}$ sont obtenus, à partir d'un oscillateur dit oscillateur local, en sorties d'un amplificateur antiphase comprenant un amplificateur différentiel sur une entrée duquel le signal de l'oscillateur local est appliqué.

Le dispositif selon l'invention présente alors un avantage supplémentaire sur le dispositif constituant l'état de la technique. Cet avantage réside dans le fait que l'isolation entre les signaux d'entrée RF, de sortie IF et le signal de l'oscillateur local est grandement améliorée.

L'invention sera mieux comprise à l'aide de la description suivante illustrée par les figures annexées dont :

-la figure 1 qui représente l'étage mélangeur élémentaire selon l'invention ;

-la figure 2 qui représente l'étage mélangeur selon une réalisation particulière ;

-la figure 3 qui représente un schéma équivalent de l'étage mélangeur selon l'invention ;

-la figure 4 qui représente un dispositif formé de deux étages mélangeurs élémentaires couplés et asociés à un amplificateur antiphase.

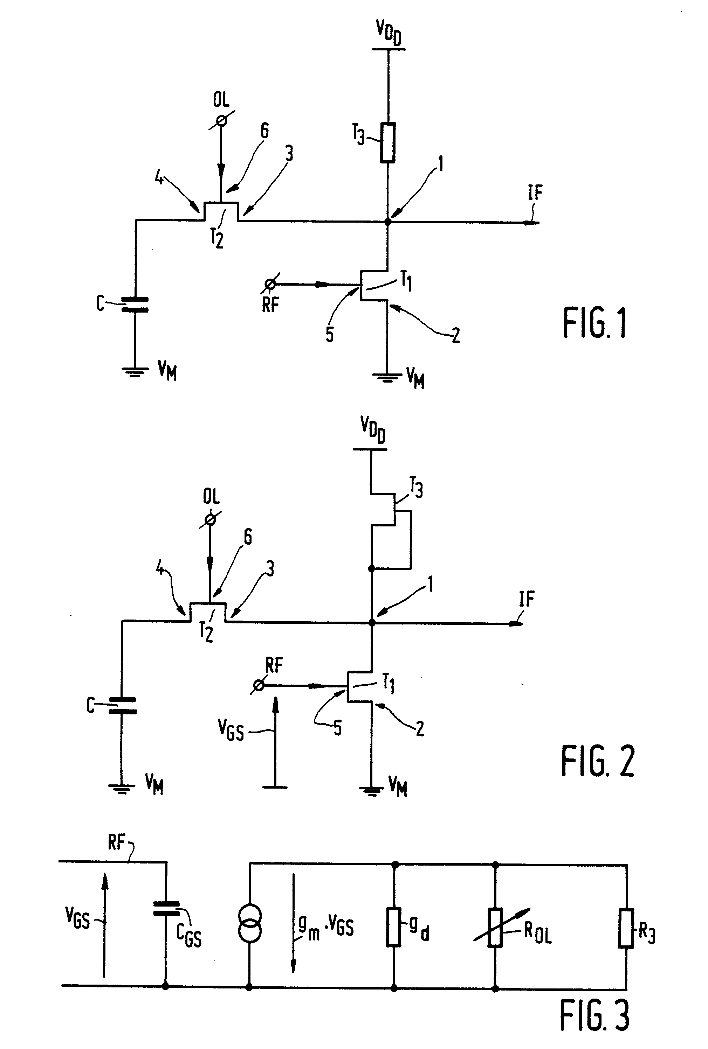

Tel que représenté sur la figure 1, l'étage amplificateur sur lequel est fondée la conception du mélangeur, est un étage inverseur. Il est formé d'un premier transistor à effet de champ $T_1$ dont la première borne principale 1 dite électrode de drain est polarisée par une tension continue $V_{DD}$ à travers une charge $T_3$ et dont la seconde borne principale 2 dite électrode de source est portée directement à un potentiel continu de référence $V_M$, par exemple la masse. La borne de commande 5 dite électrode de grille reçoit un premier signal RF à une première fréquence dite de référence. Ce signal RF peut être le signal issu d'une "tête" de réception d'antenne hyperfréquences par exemple.

Le gain A en tension de cet étage inverseur est donné par la relation (1) :

$$A = -R \times g_m \quad (1)$$

Dans laquelle $g_m$ est la transconductance du transistor $T_1$ et R est la valeur de sa charge totale.

Pour réaliser la fonction de mélangeur à l'aide de cet étage amplificateur, le gain en tension A est modulé. Cette modulation est engendrée, dans le dispositif selon l'invention, par la modulation de la charge R.

La modulation de la charge R est obtenue par la variation d'une résistance variable $T_2$, par l'intermédiaire de laquelle un second signal OL à une seconde fréquence est appliqué sur la première borne principale 1 (drain) du transistor $T_1$.

Cette résistance variable $T_2$ peut être avantageusement constituée par un transistor à effet de champ, dont l'une des bornes principales 4 est reliée au potentiel de référence $V_M$ par l'intermédiaire d'une capacité C destiné à l'isolement en continu, dont la seconde borne principale 3 est reliée au drain 1 du transistor $T_1$ amplificateur, et dont l'électrode de commande 6 (grille) reçoit le second signal OL. Ce signal peut provenir d'un oscillateur local.

le transistor $T_2$ utilisé comme résistance variable n'est donc traversé par aucun courant continu, il est polarisé en zone triode. L'application du signal OL sur sa grille 6 n'entraînera donc pas de variation de la polarisation du transistor $T_1$. Ceci permet de relier le transistor $T_2$ directement à la première borne principale 1 (drain) du transistor amplificateur $T_1$, et, éventuellement, de polariser ce transistor par une charge $T_3$ de type résistif.

Ce principe est foncièrement différent de celui qui était utilisé dans le dispositif considéré comme état de la technique, où le gain en tension était une fonction à la fois de la valeur de la résistance de charge appliquée sur le drain, de la valeur de la résistance variable et de la valeur de la résistance appliquée sur la source du transistor formant l'étage amplificateur, ce dernier étant du type amplificateur à contre-réaction de courant, la variation du gain étant obtenue par modulation de la résistance appliquée sur la source, du fait que le signal de l'oscillateur local étant lui-même appliqué sur cette source à travers la résistance variable.

Selon la présente invention, la suppression du transistor source de courant appliqué sur la source 2 du transistor amplificateur, entraîne une simplification du montage, une polarisation plus aisée ainsi qu'une amélioration considérable du facteur de bruit ; et l'application du second signal OL sur le drain 1 du transistor amplificateur, entraîne une prévision du gain par calcul plus aisé, donc une mise en oeuvre du circuit plus simple et moins coûteuse.

Le signal de sortie IF formé par le mélange du premier signal RF et du second signal OL est disponible sur la première borne principale 1 (drain) du transistor $T_1$ amplificateur. Le gain de conversion A est très bon, et l'isolation entre le premier signal dit de référence RF et le second signal OL issu par exemple d'un oscillateur local est améliorée par rapport à l'art antérieur, car il n'y a pas, dans le montage selon l'invention possibilité de retour du signal OL sur la grille du transistor $T_1$.

La figure 2 montre une variante du montage de l'étage mélangeur selon l'invention dans lequel la charge $T_3$ est constituée par un transistor à effet de champ monté en source de courant.

Un schéma équivalent simplifié de l'étage mélangeur élémentaire précédent, est réalisé sur la figure 3. Ce schéma permet d'effectuer un calcul au premier ordre du gain de conversion de l'étage amplificateur selon l'invention.

Ce gain de conversion A est donné par la relation (2) :

$$A = -(R_3 . R_{OL}) (R_{OL} + R_3 + g_d R_{OL} R_3)^{-1} \times g_m \quad (2)$$

dans laquelle $R_{OL}$ représente la résistance du transistor utilisé comme résistance variable $T_2$, $R_3$ représente la valeur de la résistance de la charge $T_3$, et $g_d$ représente la conductance du drain du transistor amplificateur $T_1$.

Cette relation montre que le gain du dispositif selon l'invention peut être calculé et optimisé de façon simple en fonction du dimensionnement des transistors.

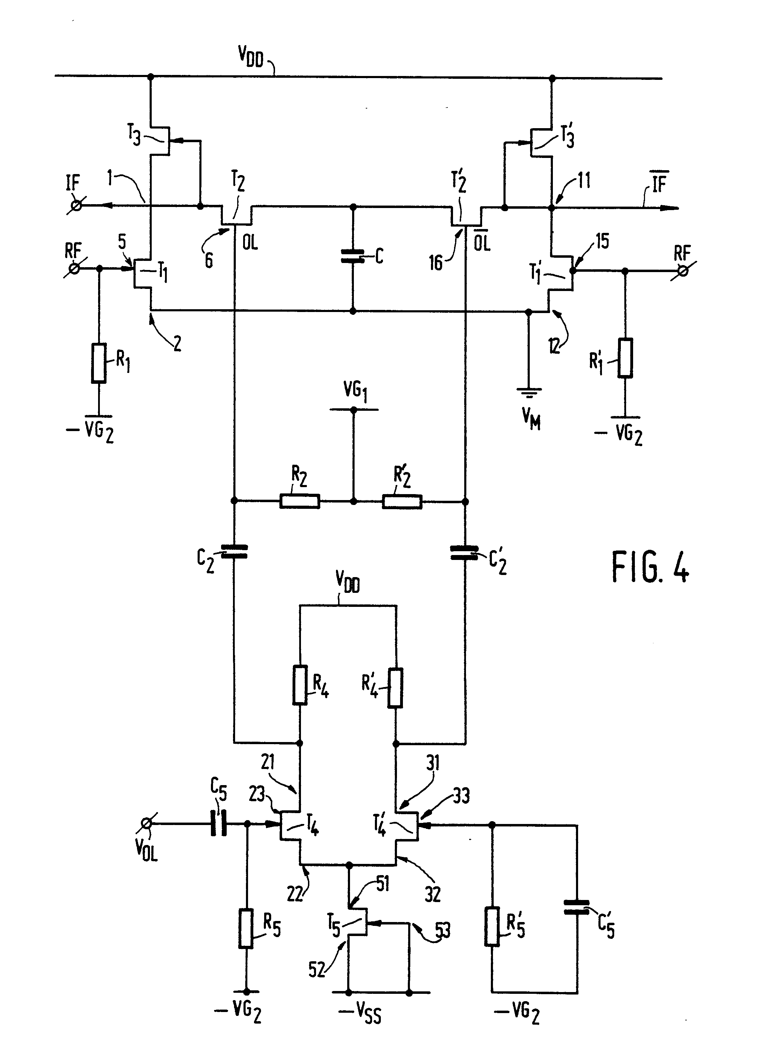

La figure 4 montre un exemple de réalisation d'un circuit mélangeur équilibré incluant deux étages mélangeurs élémentaires selon l'invention couplés formant deux branches.

La première branche comprend le premier étage mélangeur formé des transistors $T_1$, $T_2$, $T_3$ et la seconde branche comprend le second étage mélangeur formé des transistors $T'_1$, $T'_2$, $T'_3$ correspondants identiques.

Ces deux branches sont couplées par la mise en commun de la capacité C d'isolation en continu de chacun des transistors $T_2$ et $T'_2$ utilisés comme résistances variables des deux étages mélangeurs.

Chacun de ces étages mélangeurs reçoit sur l'électrode de commande, ou grille (5,15) des transistors amplificateurs respectivement $T_1$ et $T'_1$, le signal d'entrée de référence RF.

L'un de ces étages mélangeurs fournit sur la première borne principale 1 (drain) de son transistor amplificateur par exemple $T_1$, le signal de sortie IF, en recevant sur la borne de commande 6 (grille) de son transistor utilisé comme résistance variable par exemple $T_2$, le second signal OL.

L'autre étage mélangeur fournit alors sur la première borne principale 11 (drain) de son transistor amplificateur $T'_1$, le signal de sortie complémentaire $\overline{IF}$, en recevant sur la borne de commande 16 - (grille) de son transistor utilisé comme résistance variable $T'_2$ le complémentaire $\overline{OL}$ du second signal.

Afin de fournir le second signal OL et son complémentaire $\overline{OL}$ de façon appropriée, il est adjoint au montage précédent un amplificateur différentiel antiphase destiné à fournir le second signal OL et son complémentaire $\overline{OL}$ à partir du signal $V_{OL}$ issu directement par exemple d'un oscillateur local.

Les branches de cet amplificateur différentiel sont formées pour l'une du transistor à effet de champ $T_4$ dont le drain 21 est relié à la tension d'alimentation $V_{DD}$ à travers la charge $R_4$ et pour l'autre du transistor à effet de champ $T'_4$ dont le drain 31 est relié à la tension $V_{DD}$ à travers la charge $R'_4$. Les électrodes 22 et 32 de source des transistors $T_4$ et $T'_4$ sont couplées au drain 51 d'un transistor à effet de champ $T_5$ monté en source de courant, dont la source 52 et la grille 53 court-circuitées sont portées à un potentiel $-V_{SS} < V_M$

Le signal $V_{OL}$ de l'oscillateur local est appliqué par exemple sur l'électrode de commande 23 du transistor $T_4$ de l'amplificateur différentiel par l'intermédiaire d'un circuit incluant la capacité $C_5$, placée en série sur l'entrée, et la résistance $R_5$ placée entre l'électrode de commande (grille) du transistor $T_4$ et un potentiel continu $-VG_2$ tel que :

$$-V_{SS} < -VG_2 < V_M$$

L'amplificateur différentiel est équilibré par le placement sur l'électrode de commande 33 du transistor $T'_4$ de la seconde branche, d'une résistance $R'_5$ et d'une capacité $C'_5$ montées en parallèle et reliées au potentiel $-VG_2$.

La sortie OL et son complémentaire $\overline{OL}$ de cet amplificateur différentiel antiphase, sont respectivement reportées par l'intermédiaire des capacités $C_2$ et $C'_2$, sur les électrodes de commande 6 et 16 (grille) des transistors $T_2$ et $T'_2$ des étages mélangeurs couplés.

La polarisation et l'équilibrage du montage incluent encore le placement des résistances $R_2$ et $R'_2$ respectivement entre les électrodes de commandes 6 et 16 de ces transistors $T_2$ et $T'_2$ et un potentiel continu $VG_1$ tel que :

$$V_M < VG_1 < V_{DD}$$

ainsi que le placement des résistance $R_1$ et $R'_1$ respectivement entre les électrodes de commande 5 et 15 des transistors $T_1$ et $T'_1$ et le potentiel $-VG_2$.

L'ensemble du circuit décrit dans cet exemple de réalisation, c'est-à-dire à la fois les étages mélangeurs couplés et l'amplificateur différentiel antiphase, peut être intégré de façon avantageuse sur un substrat en arséniure de gallium, dont les propriétés sont particulièrement favorables à la réalisation de circuits hyperfréquences, et en particulier des circuits utilisés en bande UHF.

Les transistors à effet de champ utilisés peuvent être du type à désertion de charges (c'est-à-dire normalement passant en l'absence de signal grille-source).

Les tableux I et II donnent alors respectivement la largeur de grille des transistors et la valeur des résistances utilisées, dans les conditions où les tensions d'alimentation sont les suivantes :

4

$$V_{DD} = + 4 \text{ V} \qquad -V_{SS} = -3 \text{ V}$$
$$V_{G_1} = + 1 \text{ V} \qquad -V_{G_2} = -1 \text{ V}$$
$$V_{H} = 0 \text{ V (la masse)} \quad V_T \simeq -2 \text{ V}$$

$V_T$ étant la tension de pincement des transistors à effet de champ.

Dans l'hypothèse de l'intégration du circuit précédemment décrit, sur un substrat en arséniure de gallium, la capacité C, placée entre les transistors $T_2$ et $T'_2$, et la masse, et présentant un forte valeur de l'ordre de 1 nF ne sera pas intégrée.

Le circuit décrit montre alors les performances suivantes :

Gain de conversion $G_C \cong 4$ dB par voie

Consommation en puissance $P \cong 75$ mW.

Comme il a été dit précédemment, ce circuit mélangeur peut être utilisé dans les applications hyperfréquences et en bande UHF et tout particulièrement dans le traitement du signal issu d'une "tête de réception" d'antenne utilisée dans la réception des émissions de télévision en bande UHF. Dans cette application, le signal de référence RF est le signal fourni par l'antenne à une première fréquence $f_1$ comprise entre 460 et 860 MHz. Le signal de l'oscillateur local OL est à une seconde fréquence $f_2$ comprise entre 430 et 830 MHz.

Le circuit décrit présente l'avantage d'être à la fois très performant, simple et intégrable, ce qui est très favorable à une telle application de fabrication grand public.

## TABLEAU I

| Transistors | Largeur de grille ( m) |
|---|---|
| $T_3$, $T'_3$ | 48 μm |
| $T_2$, $T'_2$ | 14 μm |
| $T_1$, $T'_1$ | 24 μm |
| $T_4$, $T'_4$ | 24 μm |
| $T_5$ | 24 μm |

## TABLEAU II

| Résistances et capacités | Valeurs |
|---|---|
| $R_1$, $R'_1$ | 20 kΩ |
| $R_2$, $R'_2$ | 20 kΩ |
| $R_4$ | 1 kΩ |
| $R'_4$ | 1,1 kΩ |
| $C_5$, $C'_5$ | 1 pF |
| $C_2$, $C'_2$ | 1 pF |
| $R_5$, $R'_5$ | 20 kΩ |
| C | 1 nF |

**Revendications**

1. Dispositif semiconducteur du type mélangeur, formé d'au moins un étage amplificateur à gain variable incluant un premier transistor à effet de champ $T$, dont la première borne principale dite drain est polarisée à travers une charge $T_3$ par une alimentation continue $V_{DD}$, et dont la borne de commande dite grille reçoit un premier signal RF pour être mélangé à un second signal OL appliqué au premier transistor à effet de champ $T$, à travers une résistance variable $T_2$, en sorte que le signal de sortie IF de l'étage amplificateur disponible sur la première borne principale dite drain du premier transistor $T$, est formé du mélange du premier et du second signal, caractérisé en ce que le second signal OL est appliqué à travers la résistance variable $T_2$ sur la première borne principale dite drain du premier transistor $T_1$, en sorte que la variation du gain de l'amplificateur est engendrée par la modulation de la charge constituée par $T_3$ et $T_2$.

2. Dispositif selon la revendication 1, caractérisé en ce que la résistance variable $T_2$ et une capacité C destinée à l'isolement en continu sont reliées en série entre la première borne principale dite drain du premier transistor $T$, et un potentiel de référence $V_M$.

3. Dispositif selon la revendication 2, caractérisé en ce que la seconde borne principale dite source du premier transistor $T$, est directement portée au potentiel de référence $V_M$.

4. Dispositif selon la revendication 3, caractérisé en ce que la charge $T_3$ est constituée par une résistance.

5. Dispositif selon la revendication 3, caractérisé en ce que la charge $T_3$ est constituée par un transistor à effet de champ.

6. Dispositif selon la revendication 4 ou 5, caractérisé en ce que la résistance variable $T_2$ est constituée par un transistor à effet de champ monté en triode.

7. Dispositif selon l'une des revendications 1 à 6, caractérisé en ce qu'il est formé de deux amplificateurs à gain variable identiques et couplés, recevant respectivement le second signal OL et son complémentaire $\overline{OL}$ et fournissant le signal de sortie IF et son complémentaire $\overline{IF}$ .

8. Dispositif selon la revendication 7, caractérisé en ce que le second signal OL et son complémentaire $\overline{OL}$ , sont fournis à partir d'un oscillateur dit oscillateur local, par l'intermédiaire d'un amplificateur antiphase formé d'un amplificateur différentiel sur une entrée duquel le signal de l'oscillateur local est appliqué.

FIG.1

FIG. 2

FIG. 3

1-II-PHF 85-584

FIG. 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | US-A-4 032 851 (HOOVER) <br> * Colonne 1, ligne 46 - colonne 4, ligne 31; figures 1,3,4 * | 1 | H 03 D 7/12 <br> H 03 D 7/14 |
| A | | 3,4,6 | |
| | --- | | |
| A | IEEE TRANSACTIONS ON ELECTRON DEVICES, vol. ED-28, no. 2, février 1981, pages 166-170, IEEE, New York, US; R.L. VAN TUYL: "A monolithic GaAs IC for heterodyne generation of RF signals" <br> * Page 168, colonne de droite, ligne 1 - page 169, colonne de droite, ligne 21; figures 5-9 * | 1,3-8 | |
| | --- | | |
| A | EP-A-0 087 336 (THOMSON-CSF) <br> * Page 6, ligne 28 - page 7, ligne 28; figure 5 * | 1,3 | **DOMAINES TECHNIQUES RECHERCHES (Int. Cl.4)** <br><br> H 03 D |
| | --- | | |
| A | US-A-4 344 188 (TANABE et al.) <br> * Colonne 4, lignes 6-31; figure 3 * | 7,8 | |
| | ----- | | |

Le présent rapport de recherche a été établi pour toutes les revendications

| Lieu de la recherche | Date d'achèvement de la recherche | Examinateur |
|---|---|---|
| LA HAYE | 10-02-1987 | BALBINOT H. |